# EUROPEAN PATENT APPLICATION

(11) **EP 4 775 529 A1**
(43) Date of publication of application: **15.07.2026**
(21) Application number: 24944457.1
(22) Date of filing: 23.12.2024
(51) Int. Cl.: B81C 3/00, B81C 1/00, B81B 7/02, B81B 7/04, B81B 5/00, G01L 9/12, G01L 1/14

(54) **MEMS PRESSURE SENSOR AND MANUFACTURING METHOD THEREFOR, AND ELECTRONIC DEVICE**

(30) Priority: 25.06.2024 CN 202410835058
(71) Applicant: China Resources Microelectronics Holdings Limited, Jingan District Shanghai 200072 (CN)
(72) Inventor: JIN, Wenchao, Shanghai 200072 (CN); LI, Shaoping, Shanghai 200072 (CN); ZHANG, Bing, Shanghai 200072 (CN); ZHU, Encheng, Shanghai 200072 (CN); YANG, Guoqing, Shanghai 200072 (CN); YAN, Kai, Shanghai 200072 (CN); GAO, Duoduo, Shanghai 200072 (CN); DONG, Yang, Shanghai 200072 (CN); WANG, Jie, Shanghai 200072 (CN)
(74) Representative: HGF
(86) International application number: PCT/CN2024/141582
(87) International publication number: WO 2026/000893

(57) **Abstract**

This application provides a MEMS pressure sensor, a manufacturing method therefor, and an electronic device. The method includes the followings. On a surface of a first substrate, at least two first pressure structures are formed and spaced apart from each other. Each of the first pressure structures includes, from bottom to top, a first electrode layer, a first sacrificial layer, a first support layer, a second electrode layer, and a second support layer, and further includes a first cavity. On a surface of a second substrate, at least two second pressure structures are formed and spaced apart from each other. Each of the second pressure structures includes, from bottom to top, a third electrode layer and a second sacrificial layer. The second pressure structure further includes a second cavity. The second support layer and the second sacrificial layer are bonded. The first cavity and the second cavity are positioned relative to each other. The second substrate is removed to expose the third electrode layer. The third electrode layer and the second electrode layer form a capacitance-variable structure. The second electrode layer and the first electrode layer form a reference capacitance structure. The at least two capacitance-variable structures and the at least two reference capacitance structures collectively form a Wheatstone bridge.

## Description

### RELATED APPLICATION

The present application claims priority to Chinese patent application No. 202410835058.1, filed on June 25, 2024, entitled "MEMS PRESSURE SENSOR, MANUFACTURING METHOD THEREFOR, AND ELECTRONIC DEVICE", and the content of which is hereby incorporated by reference in its entirety.

### TECHNICAL FIELD

The present application relates to the technical field of semi-conductor, particular to a MEMS pressure sensor, a manufacturing method therefor, and an electronic device.

### BACKGROUND

Micro-Electro-Mechanical System (MEMS) pressure sensors belong to a cutting-edge research field developed on the basis of MEMS technology. It is applicable to harsh environments such as high impact, high overload, conductive, corrosive, and radioactive conditions, and are widely applied in fields such as aerospace, electronics, industry, medical healthcare, and environmental monitoring. Compared with piezoresistive pressure sensors, capacitive pressure sensors offer advantages such as high sensitivity, low power consumption, and good temperature characteristics, and are thus widely used in various fields.

According to the capacitance formula, the capacitive pressure sensors can be further divided into three types: spacing-variable type, area-variable type, and dielectric-variable type. Due to ease implementation, spacing-variable capacitive pressure sensors are most common. Its principle is that changes in spacing lead to changes in capacitance values, and then amplification is performed after integrated circuits obtain signals. However, the spacing-variable capacitive pressure sensors in the related technology have technical problems such as high impedance, weak load capacity, and low measurement accuracy.

### SUMMARY

In the section of Summary, a series of concepts in simplified forms are introduced, which will be further described in detail in the section of Detailed Description. The section of Summary of this application does not intend to define the critical features and essential technical features of the claimed technical solution, nor does it attempt to determine the protection scope of the claimed technical solution.

In view of the existing technical problems, a manufacturing method for a MEMS pressure sensor is provided in an aspect of the present application, which include:
providing a first substrate, wherein on a surface of the first substrate, at least two first pressure structures are formed and spaced apart from each other, each of the first pressure structures comprises, from bottom to top, a first electrode layer, a first sacrificial layer, a first support layer, a second electrode layer, and a second support layer, and each of the first pressure structures further comprises a first cavity positioned between the first support layer and the first electrode layer, and a plurality of first release holes penetrating the second support layer, the second electrode layer, and the first support layer to expose the first cavity; providing a second substrate, wherein on a surface of the second substrate, at least two second pressure structures are formed and spaced apart from each other, each of the second pressure structures comprises, from bottom to top, a third electrode layer and a second sacrificial layer, and the second pressure structure further comprises a second cavity positioned in the second sacrificial layer and exposing the third electrode layer; bonding the second support layer and the second sacrificial layer, wherein the first cavity and the second cavity are positioned corresponding to each other; removing the second substrate to expose the third electrode layer, wherein the third electrode layer and the second electrode layer form a capacitance-variable structure, the second electrode layer and the first electrode layer form a reference capacitance structure, and the two capacitance-variable structures and the two reference capacitance structures collectively form a Wheatstone bridge.

In some embodiments, the second pressure structure further includes a third support layer positioned on the second sacrificial layer. A plurality of second release holes penetrating the third support layer and exposing the second cavity are formed in the third support layer. The second support layer and the third support layer are bonded during the bonding. The plurality of the first release holes and the plurality of the second release holes are separately positioned in one-to-one correspondence.

In some embodiments, after exposing the third electrode layer, the method further includes forming one or more first bonding pads and one or more second bonding pads. Each of the first bonding pads electrically connects the first electrode layer and the third electrode layer. Each of the second bonding pads electrically is connected to the second electrode layer.

For example, the third electrode layer includes a first sub-electrode layer and a second sub-electrode layer both being spaced apart from each other. The second cavity exposes the first sub-electrode layer. The second sub-electrode layer is positioned outside the second cavity. Each of the first bonding pads is disposed on the first sub-electrode layer. Each of the second bonding pads is disposed on the second sub-electrode layer. The first sub-electrode layer and the second electrode layer form a capacitance-variable structure.

The first pressure structure further includes a first conductive contact penetrating the second support layer, the second electrode layer, the first support layer, the first sacrificial layer and electrically connecting the first electrode layer, and a second conductive contact penetrating the second support layer and electrically connecting the second electrode layer.

The second pressure structure further includes a third conductive contact penetrating the second sacrificial layer and electrically connecting the first sub-electrode layer and a fourth conductive contact penetrating the second sacrificial layer and electrically connecting the second sub-electrode layer.

During the bonding, the first conductive contact and the third conductive contact are electrically connected to form a first conductive structure. The second conductive contact and the fourth conductive contact are electrically connected to form a second conductive structure. The first bonding pads are electrically connected to the first electrode layer through the first conductive structure. The second bonding pads are electrically connected to the second electrode layer through the second conductive structure.

In some embodiments, materials of the first conductive contact, the second conductive contact, the third conductive contact, and the fourth conductive contact include copper. The bonding is performed using a copper hybrid bonding process.

In some embodiments, a first insulative layer is formed between the first substrate and the first electrode layer. A material of the first insulative layer includes any one of silicon oxides, silicon nitrides, or silicon oxynitrides.

In some embodiments, a second insulative layer is further formed between the second substrate and the third electrode layer. A material of the second insulative layer includes any one of silicon oxides, silicon nitrides, and silicon oxynitrides.

A MEMS pressure sensor is provided in another aspect of the present application, which includes the followings.

The MEMS pressure sensor includes a first substrate.

The MEMS pressure sensor includes at least two first pressure structures spaced apart from each other and formed on a surface of the first substrate. Each of the first pressure structures includes, from bottom to top, a first electrode layer, a first sacrificial layer, a first support layer, a second electrode layer, and a second support layer, and each of the first pressure structures further includes a first cavity between the first support layer and the first electrode layer, and a plurality of first release holes penetrating the second support layer, the second electrode layer, and the first support layer and exposing the first cavity.

The MEMS pressure sensor includes at least two second pressure structures spaced apart from each other and formed on the second support layer. Each of the second pressure structures includes, from bottom to top, a second sacrificial layer and a third electrode layer. Each of the second pressure structures further includes a second cavity positioned in the second sacrificial layer and exposing the third electrode layer. The second cavity and the first cavity are positioned relative to each other;

The third electrode layer and the second electrode layer form a capacitance-variable structure. The second electrode layer and the first electrode layer form a reference capacitance structure. The at least two capacitance-variable structures and the at least two reference capacitance structures collectively form a Wheatstone bridge.

In some embodiments, the second pressure structure further includes a third support layer on which the second sacrificial layer is positioned. A plurality of second release holes penetrating the third support layer and exposing a second cavity are formed in the third support layer. The plurality of the first release holes and the plurality of the second release holes are separately positioned in one-to-one correspondence.

In some embodiments, the third electrode layer includes a first sub-electrode layer and a second sub-electrode layer. The second cavity exposes the first sub-electrode layer. The second sub-electrode layer is positioned outside the second cavity. The MEMS pressure sensor further includes the followings.

The MEMS pressure sensor further includes one or more first conductive structures. Each of the first conductive structures penetrates the second sacrificial layer, the second support layer, the second electrode layer, the first support layer, and the first sacrificial layer, and electrically connects the first electrode layer and the first sub-electrode layer.

The MEMS pressure sensor further includes one or more second conductive structures. Each of the second conductive structures penetrates the second sacrificial layer and the second support layer, and electrically connects a second electrode layer and a second sub-electrode layer.

The MEMS pressure sensor further includes one or more first bonding pads disposed on the first sub-electrode layers. Each of the first bonding pads is electrically connected to a first electrode layer through one of the first conductive structures.

The MEMS pressure sensor further includes one or more second bonding pads disposed on the second sub-electrode layers. Each of the second bonding pads is electrically connected to a second electrode layer through one of the second conductive structures.

In some embodiments, materials of the first conductive structures and the second conductive structures include copper.

In some embodiments, the sensor further includes a first insulative layer positioned between the first substrate and the first electrode layer. A material of the first insulative layer includes any one of silicon oxides, silicon nitrides, and silicon oxynitrides.

In some embodiments, the sensor further includes a second insulative layer positioned between the second substrate and the third electrode layer, a material of the second insulative layer includes any one of silicon oxides, silicon nitrides, and silicon oxynitrides.

An electronic device is further provided in yet another aspect of the present application. The electronic device includes the MEMS pressure sensor according to any one of the embodiments.

According to the MEMS pressure sensor, the manufacturing method therefor, and the electronic device, the third electrode layer and the second electrode layer form a capacitance-variable structure, the second electrode layer and the first electrode layer form a reference capacitance structure, and the at least two capacitance-variable structure and the at least two reference capacitance structure collectively form a Wheatstone bridge. Measuring pressure through this Wheatstone bridge effectively improves the technical problems of high output impedance and weak load capacity existing in conventional capacitance pressure sensors, and increases measurement accuracy, thereby enhancing device performance. In addition, the vertical Wheatstone bridge structure is capable of reducing the planar size of the device, thereby conserving the costs.

### BRIEF DESCRIPTION OF THE DRAWINGS

In order to illustrate the technical solutions more clearly in the embodiments of the present application or related art, the accompanying drawings required in the description of the embodiments or related art are briefly introduced below. Obviously, the accompanying drawings in the description below merely involve some embodiments of the present application, and those skilled in the art can also obtain other accompanying drawings based on these drawings without inventive efforts.
FIG. 1 is a flowchart of a manufacturing method for a MEMS pressure sensor according to an embodiment of the present application.
FIG. 2A to FIG. 2E are schematic cross-sectional diagrams of a device, which are sequentially obtained by performing a manufacturing method for a MEMS pressure sensor according to some embodiments of the present application.
FIG. 3 is a schematic diagram of a circuit structure of a Wheatstone bridge according to an embodiment of the present application.

### DETAILED DESCRIPTION

The present application is described more clearly hereinafter in conjunction with the accompanying drawings in which embodiments of the present application are shown. However, the technical solutions of the present application may be implemented in various forms and should not be construed as limited to the embodiments set forth herein. Rather, provided embodiments make the present application being disclosed thoroughly and completely. Apparently, the accompanying drawings described below only involve some embodiments of the present application. For those skilled in the art, other accompanying drawings can be obtained according to these drawings without inventive efforts. In the accompanying drawings, for clear description, the dimensions or relative dimensions of layers and regions may be exaggerated. Same reference numerals refer to the same elements throughout.

It should be understood that when an element or layer is referred to as being "on", "adjacent to", "connected to", or "coupled to" another element or layer, the element or layer can be directly on, adjacent to, connected to, or coupled to the other element or layer, or intervening elements or layers may be present. In contrast, when an element is referred to as being "directly on", "directly adjacent to", "directly connected to", or "directly coupled to" another element or layer, there is no intervening element or layer present. It should be understood that although the terms such as first, second, and third can be used herein to describe various elements, components, regions, layers, and/or parts, and these elements, components, regions, layers, and/or parts should not be limited by these terms. These terms are only used to distinguish an element, a component, a region, a layer, or a part from another element, component, region, layer, or part. Thus, first elements, first components, first regions, first layers, or first parts described below can be referred to as second elements, second component, second region, second layer, or second parts without departing from the teachings of the present application.

Spatial relationship terms such as "under", "below", "lower", "beneath", "over", and "upper" are used herein for convenience of description to describe the relationship of an element or feature to another element or feature as illustrated in the accompanying drawings. It should be understood that the spatial relationship terms are intended to encompass different orientations of the elements in use or operation in addition to the orientations depicted in the drawings. For example, if elements in the drawings are flipped, the elements or features described as "below other elements", "beneath them", or "under them" shall be oriented "above" other elements or features. Thus, the exemplary terms "below" and "under" can include both upward and downward orientations. The elements may be otherwise oriented (rotated 90 degrees or at other orientations) and the spatial descriptors used herein interpreted accordingly.

The terms used herein is for the purpose of describing specific embodiments only and is not intended to limit the present application. As used herein, the singular forms "a", "an", and "the/said" are intended to include the plural forms as well, unless the context clearly indicates otherwise. It should be further understood that the terms "consist of" and/or "include", when used in this specification, the presence of features, integers, steps, operations, elements, and/or components are specified, but do not preclude the presence of one or more other features, integers, steps, operations, elements, components, and/or groups thereof. As used herein, the term "and/or" includes any and all combinations of the associated listed items.

With reference to schematic cross-sectional diagrams of ideal embodiments (and intermediate structures) of the present application, embodiments of the present application are described herein. As such, variations in the shapes shown due to, for example, manufacturing techniques and/or tolerances are anticipated. Therefore, the embodiments of the present application should not be limited to the specific shapes of the regions shown herein, but include shape deviations caused by, for example, manufacturing. For instance, an implantation region shown as rectangular typically has rounded or curved features at its edges and/or an implantation concentration gradient, rather than a binary change from the implantation region to a non-implantation region. Similarly, through implantation to form a buried region may cause some implanted ions are remained in the regions between the buried region and the surface through which the implantation is performed. Thus, the regions shown in the drawings are substantially schematic, and their shapes are not intended to depict the actual shapes of the regions of the device or limit the scope of the present application.

Unless otherwise defined, all terms (including technical and scientific terms) used herein have the same meaning as commonly understood by those skilled in the art. It can also be understood that terms, such as those defined in commonly used dictionaries, should be interpreted as having a meaning consistent with their meaning in the context of the relevant field and/or this specification, and should not be interpreted in an idealized or overly formal sense unless explicitly defined herein.

In order to thoroughly understand the present application, detailed steps and structures will be set forth in the following description to illustrate the technical solutions provided in the present application. The optional embodiments of the present application are described in detail below. However, the present application may have other embodiments in addition to these elaborated embodiments.

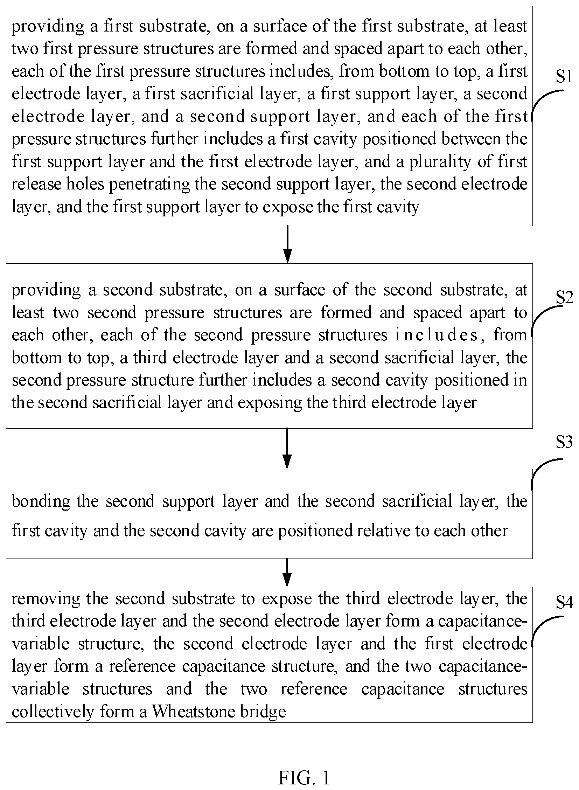

In view of the existing technical problems, a manufacturing method for a MEMS pressure sensor is provided in the present application. As shown in FIG. 1, the method mainly includes the following steps S1 to S4.

In step S1, a first substrate is provided. On a surface of the first substrate, at least two first pressure structures are formed and spaced apart from each other. Each of the first pressure structures includes, from bottom to top, a first electrode layer, a first sacrificial layer, a first support layer, a second electrode layer, and a second support layer, and each of the first pressure structures further includes a first cavity positioned between the first support layer and the first electrode layer, and multiple first release holes penetrating the second support layer, the second electrode layer, and the first support layer to expose the first cavity.

In step S2, a second substrate is provided. On a surface of the second substrate, at least two second pressure structures are formed and spaced apart from each other. Each of the second pressure structures includes, from bottom to top, a third electrode layer and a second sacrificial layer. The second pressure structure further includes a second cavity positioned in the second sacrificial layer and exposing the third electrode layer.

In step S3, the second support layer and the second sacrificial layer are bonded. The first cavity and the second cavity are positioned corresponding to each other.

In some embodiments, the first cavity and the second cavity are positioned relative to each other such that the first cavity and the second cavity are aligned with each other in the vertical direction.

In step S4, the second substrate is removed to expose the third electrode layer. The third electrode layer and the second electrode layer form a capacitance-variable structure. The second electrode layer and the first electrode layer form a reference capacitance structure. The two capacitance-variable structures and the two reference capacitance structures collectively form a Wheatstone bridge.

According to the manufacturing method for the MEMS pressure sensor in the present application, the third electrode layer and the second electrode layer form a capacitance-variable structure. The second electrode layer and the first electrode layer form a reference capacitance structure. The two capacitance-variable structures and the two reference capacitance structures collectively form a Wheatstone bridge. By using this Wheatstone bridge to measure pressures, the technical problems of high output impedance and weak load capacity existing in conventional capacitive pressure sensors are effectively addressed and the measurement accuracy is increased, thereby enhancing the device performance. In addition, the vertical Wheatstone bridge structure is capable of reducing the planar size of the device, thereby reducing the costs.

### Embodiment 1

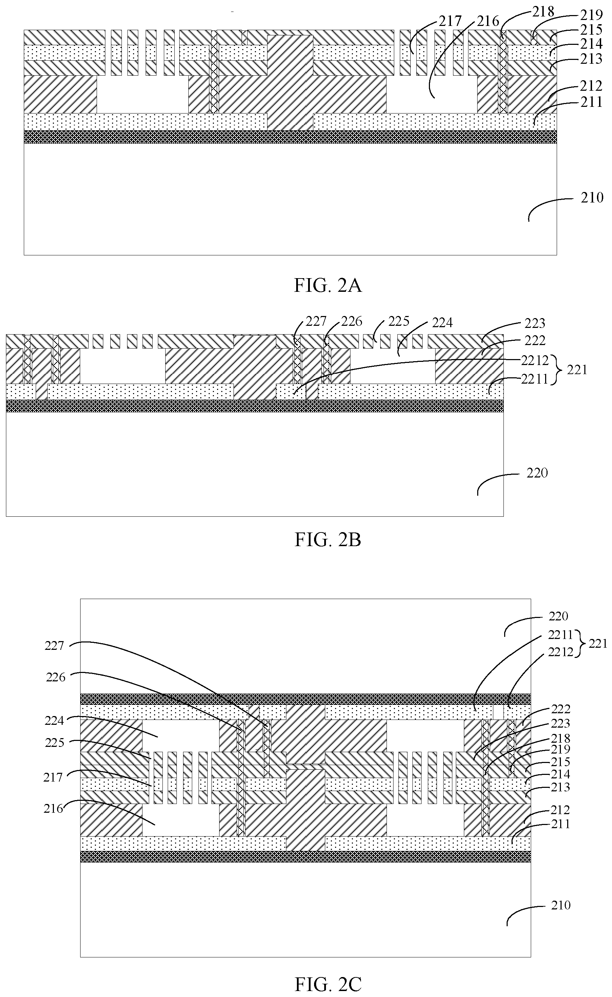

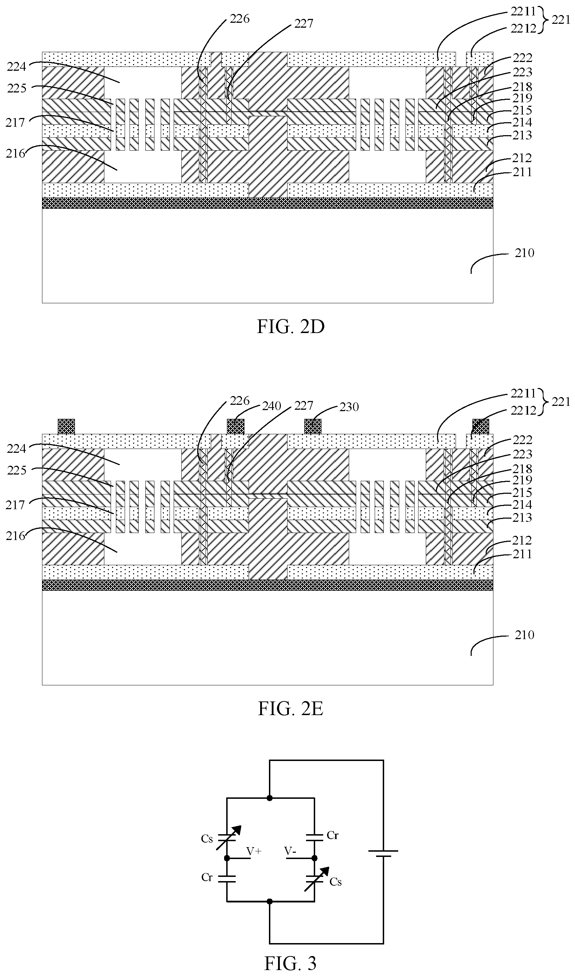

A manufacturing method for a MEMS pressure sensor of the present application is described in detail below with reference to FIG. 1, FIG. 2A to FIG. 2E, and FIG. 3. FIG. 1 shows a flowchart of the manufacturing method for the MEMS pressure sensor according to a specific embodiment in the present application. FIG. 2A to FIG. 2E show schematic cross-sectional diagrams of a device obtained by sequentially performing the manufacturing method for the MEMS pressure sensor according to some specific embodiments in the present application. FIG. 3 shows a schematic diagram of a circuit structure of a Wheatstone bridge according to a specific embodiment in the present application.

For example, the manufacturing method for the MEMS pressure sensor in the present application includes the following steps.

Firstly, step S1 is performed to provide a first substrate. On a surface of the first substrate, at least two first pressure structures are formed and spaced apart from each other. Each of the first pressure structures includes, from bottom to top, a first electrode layer, a first sacrificial layer, a first support layer, a second electrode layer, and a second support layer. Each of the first pressure structures further includes a first cavity positioned between the first support layer and the first electrode layer, and multiple first release holes penetrating the second support layer, the second electrode layer, and the first support layer to expose the first cavity.

In an example, as shown in FIG. 2A, the first substrate 210 is a bulk silicon substrate which may be made of at least one of the following materials: Si, Ge, SiGe, SiC, SiGeC, InAs, GaAs, InP, InGaAs, or other III/V compound semiconductors, and further includes multilayer structures composed of these semiconductors, or may be made of Silicon on Insulator (SOI), Stacked Silicon on Insulator (SSOI), Stacked Silicon Germanium on Insulator (S-SiGeOI), Silicon Germanium on Insulator (SiGeOI), Germanium on Insulator (GeOI), etc.

In an example, as shown in FIG. 2A, at least two first pressure structures are formed on a surface of the first substrate 310 and spaced apart from each other. Each of the first pressure structures includes, from bottom to top, a first electrode layer 211, a first sacrificial layer 212, a first support layer 213, a second electrode layer 214, and a second support layer 215. Each of the first pressure structures further includes a first cavity 216 positioned between the first support layer 213 and the first electrode layer 211, and multiple first release holes 217 penetrating the second support layer 215, the second electrode layer 214, and the first support layer 213 to expose the first cavity 216. For example, the first pressure structures being spaced apart from each other refers to that the first electrode layers 211 of the adjacent first pressure structures are spaced apart from each other, and the second electrode layers 214 of the adjacent first pressure structures are spaced apart from each other. However, other non-conductive and insulative layers of the adjacent first pressure structures may be interconnected. For example, as shown in FIG. 2A, the first sacrificial layers 212 and the second support layers 215 of the adjacent first pressure structures are interconnected, respectively, and the adjacent first electrode layers 211 and the adjacent second electrode layers 214 of the first pressure structures are isolated by the first sacrificial layers 212, respectively.

In an example, first electrode layers 211 and second electrode layers 214 may be made of doped polysilicon, SiGe, or other materials, and are not limited to a specific type. The first electrode layers 211 and the second electrode layers 214 may be formed by Chemical Vapor Deposition (CVD), Physical Vapor Deposition (PVD), Atomic Layer Deposition (ALD), or other methods, or may be formed by one of furnace tube growth and Selective Epitaxial Growth (SEG). It is not limited in the present application.

In an example, first sacrificial layers 212 are oxide layers, for example, the first sacrificial layers 212 are made of silicon oxide, Silicon Oxycarbide (SiOC), or other materials, but are not limited to this example. In addition, the first sacrificial layers 212 may be formed by various deposition methods commonly used in related art, such as Plasma-Enhanced Chemical Vapor Deposition (PECVD), Low-Pressure Chemical Vapor Deposition (LPCVD), Physical Vapor Deposition (PVD), or Atomic Layer Deposition (ALD).

In an example, the first support layers 213 and the second support layers 215 are used to improve the overall strength and stability of the device. For example, the materials of the first support layer 213 and the second support layer 215 include SiCN, SiN, SiC, SiON, etc. In other embodiments, the materials of the first support layers 213 and the second support layers 215 may also be any other suitable materials that can improve the strength and stability of the device. For example, the first support layers 213 and the second support layers 215 may be formed by various deposition methods commonly used in the field, such as Chemical Vapor Deposition (CVD), Physical Vapor Deposition (PVD), or Atomic Layer Deposition (ALD).

In an example, the first cavities 216 are obtained by removing part of the first sacrificial layers 212 through the first release holes 217. For example, a conventional etching process in the filed may be used to remove part of the first sacrificial layers 212. For example, a wet etching process may be used to remove part of the first sacrificial layers 212. More specifically, a Buffered Oxide Etchant (BOE) may be used to remove part of the first sacrificial layers 212, or Vapor HF (VHF) may be used to remove part of the first sacrificial layers 212. For example, a release boundary range of the first sacrificial layers 212 may be reasonably set according to actual requirements. The release boundary refers to the width of the remaining first sacrificial layer 212.

In an example, a first insulative layer may further be formed between the first substrate 210 and the first electrode layers 211. The material of the first insulative layer may include any one of dielectric materials. The material of the first insulative layer may include oxides, nitrides, or oxynitrides, especially silicon oxides, silicon nitrides, or silicon oxynitrides. The first insulative layer may be formed by any one of methods including ion implantation, thermal or plasma oxidation or nitridation, plasma-enhanced chemical vapor deposition, low-pressure chemical vapor deposition, or physical vapor deposition.

Step S2 is then performed, including providing a second substrate, and at least two second pressure structures are formed on a surface of the second substrate and are spaced apart from each other. Each of the second pressure structure includes, from bottom to top, a third electrode layer and a second sacrificial layer. Each of the second pressure structures further includes a second cavity positioned in the second sacrificial layer and exposing the third electrode layer.

In an example, as shown in FIG. 2B, the second substrate 220 is a bulk silicon substrate which may be made of at least one of the following materials: Si, Ge, SiGe, SiC, SiGeC, InAs, GaAs, InP, InGaAs, or other III/V compound semiconductors. The materials further include multilayer structures composed of these semiconductors, or may be Silicon on Insulator (SOI), Stacked Silicon on Insulator (SSOI), Stacked Silicon Germanium on Insulator (S-SiGeOI), Silicon Germanium on Insulator (SiGeOI), Germanium on Insulator (GeOI), etc.

In an example, as shown in FIG. 2B, on a surface of the second substrate 220, at least two second pressure structures are formed and spaced apart from each other. Each of the second pressure structures includes, from bottom to top, a third electrode layer 221 and a second sacrificial layer 222. Each of the second pressure structures further includes a second cavity 224 positioned in the second sacrificial layer 222 and exposing the third electrode layer 221. For example, the second pressure structures being spaced apart from each other refers to that the third electrode layers 221 of the adjacent second pressure structures are spaced apart from each other. However, other non-conductive and insulative layers of the adjacent second pressure structures may be interconnected. For example, as shown in FIG. 2B, the second sacrificial layers 222 of the adjacent second pressure structures are separately interconnected, and the third electrode layers 221 of the adjacent second pressure structures are separately isolated by the second sacrificial layers 222.

In an example, the third electrode layers 221 may be made of doped polysilicon, SiGe, or other materials, and is not limited to a specific type. The third electrode layers 221 may be formed by Chemical Vapor Deposition (CVD), Physical Vapor Deposition (PVD), Atomic Layer Deposition (ALD), or other methods, or may be formed by one of furnace tube growth and Selective Epitaxial Growth (SEG). It is not limited in the present application.

In an example, the second sacrificial layers 222 are oxide layer, such as silicon oxide or Silicon Oxycarbide (SiOC), but are not limited to this example. In addition, the second sacrificial layers 222 may be formed by various deposition methods commonly used in related art, such as Plasma-Enhanced Chemical Vapor Deposition (PECVD), Low-Pressure Chemical Vapor Deposition (LPCVD), physical vapor deposition, or Atomic Layer Deposition (ALD).

In an example, a second insulative layer may further be formed between the second substrate 220 and the third electrode layers 221. The material of the second insulative layer may include any one of dielectric materials including oxides, nitrides, and oxynitrides, especially silicon oxides, silicon nitrides, and silicon oxynitrides. However, oxides, nitrides, and oxynitrides of other elements are excluded. The second insulative layer may be formed by any one of the methods including ion implantation, thermal or plasma oxidation or nitridation, plasma-enhanced chemical vapor deposition, low-pressure chemical vapor deposition, or physical vapor deposition.

Step S3 is then performed to bond the second support layer and the second sacrificial layer. The first cavity and the second cavity are positioned corresponding to each other. For example, as shown in FIG. 2C, the second support layers 215 and the second sacrificial layers 222 are bonded. The first cavities 216 and the second cavities 224 are positioned corresponding to each other. In some embodiments, the first cavities 216 and the second cavities 224 being positioned to each other may refer to being aligned with each other in the vertical direction.

In an example, as shown in FIG. 2B and FIG. 2C, each of the second pressure structures further includes a third support layer 223 positioned on the second sacrificial layer 222, and multiple second release holes 225 penetrating the third support layer 223 to expose the second cavity 224 are formed in the third support layer 223. In this case, the second support layer 215 and the third support layer 223 are combined during the bonding. The first release holes 217 and the second release holes 225 are positioned corresponding to each other. For example, the third support layers 223 of the adjacent second pressure structures are interconnected.

In an example, the second cavities 224 are obtained by removing part of the second sacrificial layers 222 through the second release holes 225. For example, a conventional etching process in the field may be performed to remove part of the second sacrificial layers 222. For example, a wet etching process may be performed to remove part of the second sacrificial layer 222. More specifically, a Buffered Oxide Etchant (BOE) may be used to remove part of the second sacrificial layers 222, or Vapor HF (VHF) may be used to remove part of the second sacrificial layers 222. For example, a release boundary range of the second sacrificial layers 222 may be reasonably set according to actual requirements. The release boundary refers to the width of a remaining second sacrificial layer 222.

In an example, the third support layers 223 can further improve the strength and stability of the device. For example, the third support layers 223 are made of the same material as that of the first support layers 213 and the second support layers 215. The material includes but not limited to SiCN, SiN, SiC, SiON, etc. For example, the third support layers 223 may be formed by various deposition methods commonly used in field, such as Chemical Vapor Deposition (CVD), Physical Vapor Deposition (PVD), or Atomic Layer Deposition (ALD). For example, because the third support layers 223 and the second support layers 215 are made of the same material, the bonding is better.

Finally, step S4 is performed to remove the second substrate to expose the third electrode layer. The third electrode layer and the second electrode layer form a capacitance-variable structure. The second electrode layer and the first electrode layer form a reference capacitance structure, and the two capacitance-variable structures and the two reference capacitance structures collectively form a Wheatstone bridge. For example, the second substrate 220 may be removed by a conventional process such as thinning to expose the third electrode layer 221.

In an example, the third electrode layer 221 and second electrode layer 214 form a capacitance-variable structure, and the second electrode layer 214 and first electrode layer 211 form a reference capacitance structure. The capacitance value of the reference capacitance structure is a fixed value. The third electrode layer 221 serves as a pressure-sensitive diaphragm. When subjected to pressure, the third electrode layer 221 deforms, causing the distance between the third electrode layer 221 and the second electrode layer 214 to change, and the capacitance value of the capacitance-variable structure to alter. Since the MEMS pressure sensor of the present application includes at least two first pressure structures and at least two second pressure structures, that is, at least two capacitance-variable structures and at least two reference capacitance structures. The two capacitance-variable structures and the two reference capacitance structures form a Wheatstone bridge. As shown in FIG. 3, each of the two arms of the Wheatstone bridge is provided with a capacitance-variable structure Cs and a reference capacitance structure Cr. Specifically, one of the arms has the capacitance-variable structure Cs connected to the positive electrode of the power supply, and the other arm has the reference capacitance structure Cr connected to the positive electrode of the power supply. When pressure is applied, the capacitance value of the capacitance-variable structure Cs changes, causing the voltage value of the output voltage between the terminal V+ and the terminal V- to change. By measuring the output voltage, the change in the capacitance value of the capacitance-variable structure Cs can be obtained, and thus the corresponding pressure value can be determined, completing the pressure measurement. For example, the initial capacitance values of the capacitance-variable structure Cs and the reference capacitance structure Cr can be set to be equal, so that the Wheatstone bridge is in a balanced state with an output voltage of 0. When pressure is applied, the Wheatstone bridge becomes unbalanced, and the output voltage changes from 0. The change in the output voltage is easier to measure, making it easier to obtain the corresponding pressure value. For example, measuring pressure through a Wheatstone bridge consisting of two capacitance-variable structures and two reference capacitance structures can effectively address the technical problems of high output impedance and weak load capacity in conventional capacitive pressure sensors, improving measurement accuracy, and thereby enhancing device performance. In addition, the planar size of the device can be reduced through the vertical Wheatstone bridge structure, and thereby reducing costs.

In an example, as shown in FIG. 2E, after exposing the third electrode layer 221, the method of the present application further includes forming first bonding pads 230 and second bonding pads 240. Each of the first bonding pads 230 is electrically connected to a first electrode layer 211 and a third electrode layer 221. Each of the second bonding pads 240 is electrically connected to a second electrode layer 214. For example, the first electrode layer 211 and the third electrode layer 221 are led out through a first bonding pad 230 to connect an external circuit. The first electrode layer 211 and the third electrode layer 221 are at the same potential. The second electrode layer 214 is led out through a second bonding pad 240 to connect an external circuit. For example, the first bonding pads 230 and second bonding pads 240 may be formed by sputtering or evaporation.

In an example, as shown in FIG. 2B to FIG. 2E, the third electrode layer 221 includes a first sub-electrode layer 2211 and a second sub-electrode layer 2212 which are spaced apart from each other. The second cavity 224 exposes the first sub-electrode layer 2211, and the second sub-electrode layer 2212 is positioned outside the second cavity 224. Each of the first bonding pads 230 is disposed on the first sub-electrode layer 2211, each of the second bonding pads 240 is disposed on the second sub-electrode layer 2212, and the first sub-electrode layer 2211 and the second electrode layer 214 form a capacitance-variable structure.

In an example, as shown in FIG. 2A, the first pressure structure further includes a first conductive contact 218 penetrating the second support layer 215, the second electrode layer 214, the first support layer 213, and the first sacrificial layer 212 and electrically connecting the first electrode layer 211. The first pressure structure further includes a second conductive contact 219 penetrating the second support layer 215 and electrically connecting the second electrode layer 214. For example, the sidewalls of the first conductive contact 218 and the second conductive contact 219 are covered by the second support layer 215 to isolate the first conductive contact 218 from the second conductive contact 219. In other embodiments, the sidewalls of the first conductive contact 218 and the second conductive contact 219 may be covered by other insulative materials.

In an example, as shown in FIG. 2B, the second pressure structure further includes a third conductive contact 226 penetrating the second sacrificial layer 222 and electrically connecting the first sub-electrode layer 2211. The second pressure structure further includes a fourth conductive contact 227 penetrating the second sacrificial layer 222 and electrically connecting the second sub-electrode layer 2212. For example, when the third support layer 223 is formed, the third conductive contact 226 and the fourth conductive contact 227 also penetrate the third support layer 223. For example, the sidewalls of the third conductive contact 226 and the fourth conductive contact 227 are covered by the third support layer 223 to isolate the third conductive contact 226 from the fourth conductive contact 227. In other embodiments, the sidewalls of the third conductive contact 226 and the fourth conductive contact 227 may be covered by other insulative materials.

In an example, during the bonding, the first conductive contact 218 and the third conductive contact 226 are electrically connected to form a first conductive structure. The second conductive contact 219 and the fourth conductive contact 227 are electrically connected to form a second conductive structure. The first bonding pads 230 are electrically connected to the first electrode layer through the first conductive structure, and the second bonding pads 240 are electrically connected to the third electrode layer through the second conductive structure, which can avoid the formation of excessive step height between the first bonding pads 230 and the second bonding pads 240, thereby preventing difficulties in device packaging due to the excessive step height.

In an example, the material of the first conductive contact 218, the second conductive contact 219, the third conductive contact 226, and the fourth conductive contact 227 includes copper, and a copper hybrid bonding process is used to perform bonding. For example, the surfaces of the first conductive contact 218 and the second conductive contact 219 are slightly lower than the surface of the second support layer 215 before bonding. When the third support layer 223 is not formed, the surfaces of the third conductive contact 226 and the fourth conductive contact 227 are slightly lower than the surface of the second sacrificial layer 222 before bonding. When the third support layer 223 is formed, the surfaces of the third conductive contact 226 and the fourth conductive contact 227 are slightly lower than the surface of the third support layer 223 before bonding. During the copper hybrid bonding process, the second support layer 215 and the second sacrificial layer 222 are first bonded, or when the third support layer 223 is formed, the second support layer 215 and the third support layer 223 are bonded. Subsequently, a low-temperature annealing process is performed. Due to the high thermal expansion coefficient of copper, the first conductive contact 218 and the third conductive contact 226 are bonded due to expansion to form the first conductive structure, and the second conductive contact 219 and the fourth conductive contact 227 are bonded due to expansion to form the second conductive structure. For example, using the copper hybrid bonding process to bond, the difficulty of manufacturing the device can be effectively reduced, and the vertical integration of the device can be improved.

It is noted that the above steps are only examples, and the order of the steps may be adjusted in a case where contradictories are not present.

The description of the critical steps of the manufacturing method for the MEMS pressure sensor of the present application has been described above. The complete manufacturing of the MEMS pressure sensor may include other steps, which are not described in detail herein.

In summary, according to the manufacturing method for the MEMS pressure sensor of the present application, the third electrode layer and the second electrode layer form a capacitance-variable structure, the second electrode layer and the first electrode layer form a reference capacitance structure, and the two capacitance-variable structures and the two reference capacitance structures collectively form a Wheatstone bridge. Measuring pressure through this Wheatstone bridge effectively improves the high output impedance and weak load capacity in conventional capacitive pressure sensors, and improves measurement accuracy, and thereby enhances the device performance. Moreover, the vertical Wheatstone bridge structure reduces the planar size of the device and lowers the costs. More specifically, the first sub-electrode layer and the second electrode layer form the capacitance-variable structure. For example, the manufacturing method of the present application does not include redundant high thermal budget processes, effectively reducing the impact of thermal budget on the device. For example, the first bonding pads and second bonding pads have no excessive step height, effectively reducing the impact on packaging. For example, using the copper hybrid bonding process to bond can effectively reduce the difficulty of manufacturing the device and improve the vertical integration of the device.

### Embodiment 2

A MEMS pressure sensor manufactured by the method in Embodiment 1 is provided in the present application. As shown in FIG. 2E, the MEMS pressure sensor of the present application includes a first substrate 210 and at least two first pressure structures spaced apart from each other and formed on a surface of the first substrate 210. Each of the first pressure structures includes, from bottom to top, a first electrode layer 211, a first sacrificial layer 212, a first support layer 213, a second electrode layer 214, and a second support layer 215, and each of the first pressure structures further includes a first cavity 216 between the first support layer 213 and the first electrode layer 211, and multiple first release holes 217 penetrating the second support layer 215, the second electrode layer 214, and the first support layer 213 and exposing the first cavity 216.

The MEMS pressure sensor further includes at least two second pressure structures spaced apart from each other and formed on the second support layer 215. Each of the second pressure structures includes, from bottom to top, a second sacrificial layer 222 and a third electrode layer 221. Each of the second pressure structures further includes a second cavity 224 positioned in the second sacrificial layer 222 and exposing the third electrode layer 221. The second cavity 224 and the first cavity 216 are positioned corresponding to each other.

The third electrode layer 221 and the second electrode layer 214 form a capacitance-variable structure, the second electrode layer 214 and the first electrode layer 211 form a reference capacitance structure, and the at least two capacitance-variable structures and the at least two reference capacitance structures collectively form a Wheatstone bridge.

In an example, as shown in FIG. 2E and FIG. 3, the third electrode layer 221 and second electrode layer 214 form a capacitance-variable structure, and the second electrode layer 214 and first electrode layer 211 form a reference capacitance structure. The capacitance value of the reference capacitance structure is a fixed value. The third electrode layer 221 serves as a pressure-sensitive diaphragm. When subjected to pressure, the third electrode layer 221 deforms, causing the distance between the third electrode layer 221 and the second electrode layer 214 to change, and the capacitance value of the capacitance-variable structure to alter. Since the MEMS pressure sensor of the present application includes at least two first pressure structures and at least two second pressure structures, that is, the two capacitance-variable structures and the two reference capacitance structures form a Wheatstone bridge. As shown in FIG. 3, each of the two arms of the Wheatstone bridge is provided with a capacitance-variable structure Cs and a reference capacitance structure Cr. Specifically, one of the arms has the capacitance-variable structure Cs connected to the positive electrode of the power supply, and the other arm has the reference capacitance structure Cr connected to the positive electrode of the power supply as well. When pressure is applied, the capacitance value of the capacitance-variable structure Cs changes, causing the voltage value of the output voltage between the terminal V+ and the terminal V- to change. By measuring the output voltage, the change in the capacitance value of the capacitance-variable structure Cs can be obtained, and thus the corresponding pressure value can be determined, completing the pressure measurement. For example, the initial capacitance values of the capacitance-variable structure Cs and the reference capacitance structure Cr can be set to be equal, so that the Wheatstone bridge is in a balanced state with an output voltage of 0. When pressure is applied, the Wheatstone bridge becomes unbalanced, and the output voltage changes from 0. The change in the output voltage is easier to measure, making it easier to obtain the corresponding pressure value. Thus, measuring pressure through a Wheatstone bridge consisting of two capacitance-variable structures and two reference capacitance structures can effectively address the technical problems of high output impedance and weak load capacity in conventional capacitive pressure sensors, improving the measurement accuracy, and thereby enhancing the device performance. In addition, the vertical Wheatstone bridge structure can reduce the planar size of the device and lower the costs.

In an example, as shown in FIG. 2E, the second pressure structure further includes a third support layer 223. The second sacrificial layer 222 is positioned on the third support layer 223. Multiple second release holes 225 penetrating the third support layer 223 to expose the second cavity 224 are formed in the third support layer 223. The multiple first release holes 217 and the multiple second release holes 225 are arranged in an one-to-one correspondence.

In an example, as shown in FIG. 2B and FIG. 2E, the third electrode layer 221 includes a first sub-electrode layer 2211 and a second sub-electrode layer 2212 which are spaced apart. The second cavity 224 exposes the first sub-electrode layers 2211. The second sub-electrode layers 2212 are positioned outside the second cavities 224. The MEMS pressure sensor of the present application further includes: one or more first conductive structures. Each of the first conductive structures penetrates the second sacrificial layer 222, the second support layer 215, the second electrode layer 214, the first support layer 213, and the first sacrificial layer 212 and electrically connects a first electrode layer 211 and a first sub-electrode layer 2211. The MEMS pressure sensor further includes one or more second conductive structures. Each of the second conductive structures penetrates the second sacrificial layer 222 and the second support layer 215 and electrically connects a second electrode layer 214 and a second sub-electrode layer 2212. The MEMS pressure sensor further includes one or more first bonding pads 230 disposed on the first sub-electrode layers 2211. Each of the first bonding pads 230 electrically connects a first electrode layer 211 through a first conductive structure. The MEMS pressure sensor further includes one or more second bonding pads 240 disposed on the second sub-electrode layers. Each of the second bonding pads 240 electrically connects a second electrode layer 214 through a second conductive structure. For example, the material of the first conductive structures and the second conductive structures includes copper. For example, as shown in FIG. 2E, the first conductive structure is formed by electrically connecting the first conductive contact 218 and the third conductive contact 226. The second conductive structure is formed by electrically connecting the second conductive contact 219 and the fourth conductive contact 227. For example, the first sub-electrode layer 2211 and the second electrode layer 214 form a capacitance-variable structure.

The description to the structure of the MEMS pressure sensor of the present application is finished. The complete device may include other constituent structures, which are not described in detail herein.

According to the MEMS pressure sensor of the present application, the third electrode layer and the second electrode layer form a capacitance-variable structure. The second electrode layer and the first electrode layer form a reference capacitance structure. The at least two capacitance-variable structures and the at least two reference capacitance structures collectively form a Wheatstone bridge. Measuring pressure through this Wheatstone bridge effectively improves the high output impedance and weak load capacity in conventional capacitive pressure sensors, improving the measurement accuracy, and thereby enhancing the device performance. In addition, the vertical Wheatstone bridge structure reduces the planar size of the device and lowers the costs. For example, the first bonding pads and second bonding pads have no excessive step height, effectively reducing the impact on packaging.

### Embodiment 3

An electronic device is further provided in the present application, which includes a MEMS pressure sensor described in Embodiment 2 or a MEMS pressure sensor manufactured by the method described in Embodiment 1.

The electronic device may be any electronic product or device such as a mobile phone, a tablet computer, a laptop computer, a netbook, a game console, a television, a VCD, a DVD, a navigator, a camera, a camcorder, a voice recorder, an MP3 player, an MP4 player, a PlayStation Portable (PSP), etc., or an intermediate product with the above MEMS pressure sensor, such as a mobile phone motherboard with the MEMS pressure sensor. The electronic device of an embodiment in the present application has better performance due to the use of the above MEMS pressure sensor.

The technical features of the above embodiments may be combined arbitrarily. To make the description concise, not all possible combinations of the technical features in the above embodiments are described. However, as long as there is no contradiction between the combinations of these technical features, they should be considered as within the scope described in this specification.

The above-mentioned embodiments merely show some implementations. Even though its description is detailed, it still cannot be understood as limitations to the scope of the present invention. It should be noted that, for those skilled in the art, without departing from the inventive concept of the present application, variations and improvements can be made. These variations and improvements all belong to the protection scope of the present application. Therefore, the protection scope of the present application shall subject to the appended claims.

## Claims

1. A manufacturing method for a micro-electro-mechanical system (MEMS) pressure sensor, comprising:
providing a first substrate, wherein on a surface of the first substrate, at least two first pressure structures are formed and spaced apart from each other, each of the first pressure structures comprises, from bottom to top, a first electrode layer, a first sacrificial layer, a first support layer, a second electrode layer, and a second support layer, and each of the first pressure structures further comprises a first cavity positioned between the first support layer and the first electrode layer, and a plurality of first release holes penetrating the second support layer, the second electrode layer, and the first support layer to expose the first cavity;
providing a second substrate, wherein on a surface of the second substrate, at least two second pressure structures are formed and spaced apart from each other, each of the second pressure structures comprises, from bottom to top, a third electrode layer and a second sacrificial layer, and the second pressure structure further comprises a second cavity positioned in the second sacrificial layer and exposing the third electrode layer;
bonding the second support layer and the second sacrificial layer, wherein the first cavity and the second cavity are positioned corresponding to each other;
removing the second substrate to expose the third electrode layer, wherein the third electrode layer and the second electrode layer form a capacitance-variable structure, the second electrode layer and the first electrode layer form a reference capacitance structure, and the two capacitance-variable structures and the two reference capacitance structures collectively form a Wheatstone bridge.

2. The manufacturing method according to claim 1, wherein the second pressure structure further comprises a third support layer positioned on the second sacrificial layer, a plurality of second release holes penetrating the third support layer and exposing the second cavity are formed in the third support layer, the second support layer and the third support layer are bonded during the bonding, wherein the plurality of the first release holes and the plurality of the second release holes are positioned in a one-to-one correspondence.

3. The manufacturing method according to claim 1, wherein after exposing the third electrode layer, the method further comprises:
forming one or more first bonding pads and one or more second bonding pads, wherein each of the first bonding pads electrically connects the first electrode layer and the third electrode layer, and each of the second bonding pads electrically is connected to the second electrode layer.

4. The manufacturing method according to claim 3, wherein the third electrode layer comprises a first sub-electrode layer and a second sub-electrode layer spaced apart from each other, the second cavity exposes the first sub-electrode layer, the second sub-electrode layer is positioned outside the second cavity, each of first bonding pads is disposed on the first sub-electrode layer, each of second bonding pads is disposed on the second sub-electrode layer, and the first sub-electrode layer and the second electrode layer form a capacitance-variable structure;
the first pressure structure further comprises a first conductive contact penetrating the second support layer, the second electrode layer, the first support layer, the first sacrificial layer and electrically connecting the first electrode layer, and a second conductive contact penetrating the second support layer and electrically connecting the second electrode layer;
the second pressure structure further comprises a third conductive contact penetrating the second sacrificial layer and electrically connecting the first sub-electrode layer, and a fourth conductive contact penetrating the second sacrificial layer and electrically connecting the second sub-electrode layer;
during the bonding, the first conductive contact and the third conductive contact are electrically connected to form a first conductive structure, the second conductive contact and the fourth conductive contact are electrically connected to form a second conductive structure, the first bonding pads are electrically connected to the first electrode layer through the first conductive structure, and the second bonding pads are electrically connected to the second electrode layer through the second conductive structure.

5. The manufacturing method according to claim 4, wherein materials of the first conductive contact, the second conductive contact, the third conductive contact, and the fourth conductive contact comprise copper, and the bonding is performed using a copper hybrid bonding process.

6. The manufacturing method according to claim 1, wherein a first insulative layer is formed between the first substrate and the first electrode layer, and a material of the first insulative layer comprises any one of silicon oxides, silicon nitrides, or silicon oxynitrides.

7. The manufacturing method according to claim 1, wherein a second insulative layer is further formed between the second substrate and the third electrode layer, and a material of the second insulative layer comprises any one of silicon oxides, silicon nitrides, and silicon oxynitrides.

8. A micro-electro-mechanical (MEMS) pressure sensor, comprising:
a first substrate;
at least two first pressure structures spaced apart from each other and formed on a surface of the first substrate, wherein each of the first pressure structures comprises, from bottom to top, a first electrode layer, a first sacrificial layer, a first support layer, a second electrode layer, and a second support layer, and each of the first pressure structures further comprises a first cavity between the first support layer and the first electrode layer, and a plurality of first release holes penetrating the second support layer, the second electrode layer, and the first support layer and exposing the first cavity;
at least two second pressure structures spaced apart from each other and formed on the second support layer, wherein each of the second pressure structures comprises, from bottom to top, a second sacrificial layer and a third electrode layer, each of the second pressure structures further comprises a second cavity positioned in the second sacrificial layer and exposing the third electrode layer, and the second cavity and the first cavity are positioned relative to each other;
wherein the third electrode layer and the second electrode layer form a capacitance-variable structure, the second electrode layer and the first electrode layer form a reference capacitance structure, and the at least two capacitance-variable structures and the at least two reference capacitance structures collectively form a Wheatstone bridge.

9. The MEMS pressure sensor according to claim 8, wherein the second pressure structure further comprises a third support layer on which the second sacrificial layer is positioned, a plurality of second release holes penetrating the third support layer and exposing a second cavity are formed in the third support layer, wherein the plurality of the first release holes and the plurality of the second release holes are positioned in a one-to-one correspondence.

10. The MEMS pressure sensor according to claim 8, wherein the third electrode layer comprises a first sub-electrode layer and a second sub-electrode layer, the second cavity exposes the first sub-electrode layer, the second sub-electrode layer is positioned outside the second cavity, and the MEMS pressure sensor further comprises:
one or more first conductive structures, wherein each of the first conductive structures penetrates the second sacrificial layer, the second support layer, the second electrode layer, the first support layer, and the first sacrificial layer, and electrically connects the first electrode layer and the first sub-electrode layer;
one or more second conductive structures, wherein each of the second conductive structures penetrates the second sacrificial layer and the second support layer, and electrically connects a second electrode layer and a second sub-electrode layer;
one or more first bonding pads disposed on the first sub-electrode layers, wherein each of the first bonding pads electrically connects a first electrode layer through one of the first conductive structures;
one or more second bonding pads disposed on the second sub-electrode layers, wherein each of the second bonding pads electrically is connected to a second electrode layer through one of the second conductive structures.

11. The MEMS pressure sensor according to claim 10, wherein materials of the first conductive structures and the second conductive structures comprise copper.

12. The MEMS pressure sensor according to claim 8, wherein the sensor further comprises a first insulative layer positioned between the first substrate and the first electrode layer, and a material of the first insulative layer comprises any one of silicon oxides, silicon nitrides, and silicon oxynitrides.

13. The MEMS pressure sensor according to claim 8, wherein the sensor further comprises a second insulative layer positioned between the second substrate and the third electrode layer, a material of the second insulative layer comprises any one of silicon oxides, silicon nitrides, and silicon oxynitrides.

14. An electronic device, comprising the MEMS pressure sensor according to any one of claims 8 to 13.
